# EUROPEAN PATENT SPECIFICATION

(11) **EP 4 538 721 B1**
(45) Date of publication and mention of the grant of the patent: **04.11.2026**
(21) Application number: 22947640.3
(22) Date of filing: 28.09.2022
(51) Int. Cl.: G01R 27/08, G01R 27/02, G01R 31/69

(54) **JOINT RESISTANCE MEASUREMENT DEVICE**
VORRICHTUNG ZUR MESSUNG DES FUGENWIDERSTANDS
DISPOSITIF DE MESURE DE RÉSISTANCE D'ARTICULATION

(30) Priority: 22.06.2022 CN 202210711686
(43) Date of publication of application: 16.04.2025
(73) Proprietor: China Nuclear Power Operations Co., Ltd., Shenzhen, Guangdong 518000 (CN); China General Nuclear Power Corporation, Shenzhen, Guangdong 518028 (CN); CGN Power Co., Ltd., Shenzen, Guangdong 518028 (CN)
(72) Inventor: CHEN, Yongwei, Shenzhen, Guangdong 518000 (CN); ZHOU, Xinxing, Shenzhen, Guangdong 518000 (CN); ZHANG, Qifu, Shenzhen, Guangdong 518000 (CN); LI, Dong, Shenzhen, Guangdong 518000 (CN); SUN, Zhifeng, Shenzhen, Guangdong 518000 (CN)
(74) Representative: Westphal, Mussgnug & Partner, Patentanwälte mbB
(86) International application number: PCT/CN2022/122322
(87) International publication number: WO 2023/245900

(56) References cited:
- EP-A2- 1 022 570
- WO-A1-2020/070187
- CN-A- 102 707 149
- CN-A- 102 778 608
- CN-A- 105 277 794
- CN-A- 108 519 516
- CN-A- 111 142 050
- CN-U- 208 207 120
- CN-U- 211 528 540
- JP-A- S60 195 461
- US-A1- 2020 166 547

## Description

### TECHNICAL FIELD

The present invention relates to the technical field of joint resistance measurement, and more specifically, to a joint resistance measurement device.

### DESCRIPTION OF RELATED ART

Airline plugs or coaxial cables are often used on the site of nuclear power units. However, poor contact often occurs as the usage time increases or the equipment is frequently disassembled and assembled. Abnormal contact of this type of connectors greatly affects the transmission of signals, also has a negative impact on the reliability and stability of the equipment, and influences the monitoring of important signals and the normal operation of the control and protection system. Currently, there are various scenarios for resistance and insulation measurement of on-site instruments in nuclear power units. The testing methods currently adopted require frequent and alternating use of insulation meters and millimeters during the testing process, which is cumbersome in operation and time-consuming and labor-intensive. Meanwhile, the interface is poorly matched, for example, in the measurement of the displacement probe and the rotational speed probe of the main pump, adapter devices are needed, which has a negative impact on the reliability of the maintenance of key important and sensitive equipment. Moreover, the level of intelligence is low, and the display and operation are not intuitive.

Publication US 2020/166547 A1 is considered to be relevant to the present application and discloses a resistance measuring device with an amplifying unit including an amplifier, a first and a second current supply unit, a voltage detection unit, and a controller. The controller controls the voltage detection unit to detect a first output voltage of an output terminal of the amplifier in a state where the current of the first current source flows in a forward direction to a measurement target resistor by controlling the first current supply unit, controls the voltage detection unit to detect a second output voltage of the output terminal of the amplifier in a state where the current of the second current source flows in a reverse direction to the measurement target resistor by controlling the second current supply unit, and calculates a resistance value of the measurement target resistor based on the detected first output voltage and the detected second output voltage.

### BRIEF SUMMARY OF THE INVENTION

### Technical problem

The technical problem to be solved by the present invention is to provide a joint resistance measurement device in response to some of the above technical defects in the prior art.

### Technical Solutions

The technical solution adopted by the present invention to solve its technical problem is: to construct a joint resistance measurement device comprising: a control unit, a constant current source, a first connection end, a second connection end, a first changeover switch, a second changeover switch, a first voltage detection unit, a second voltage detection unit, a digital-to-analog conversion unit;

The first connection end and the second connection end are used to correspondingly connect the inner core and the outer core of the joint under test. The first changeover switch is respectively connected to the control unit, the first connection end, the constant current source and the first voltage detection unit, and the second changeover switch is respectively connected to the control unit, the second connection end and the second voltage detection unit.

The constant current source is connected to the control unit and is used for generating a stable current when the control unit receives a first trigger instruction. The first changeover switch and the second changeover switch are configured to be controlled to conduct by the control unit when the control unit receives the first trigger instruction. The digital-to-analog conversion unit is connected to the first voltage detection unit, the second voltage detection unit and the control unit, and is used for obtaining the detection results of the first voltage detection unit and the second voltage detection unit and outputting a corresponding first conversion value. The control unit is configured to output the continuous resistance value of the joint under test according to the first conversion value when receiving the first trigger instruction.

Preferably, in the joint resistance measurement device of the present invention, further comprising: a constant voltage source, a third connection end, a first voltage division unit, a second voltage division unit, a third changeover switch, a fourth changeover switch, a third voltage detection unit and a fourth voltage detection unit;

The third connection end is used to connect the insulating layer of the joint under test.

The constant voltage source is connected to the second connection end and the control unit, and used for outputting a stable voltage when the control unit receives a second trigger instruction;

The third changeover switch is respectively connected to the control unit, the first connection end and the first voltage division unit. The fourth changeover switch is respectively connected to the control unit, the second connection end and the second voltage division unit. The third voltage detection unit is connected to the first voltage division unit, and the fourth voltage detection unit is connected to the second voltage division unit. Moreover, the third changeover switch and the fourth changeover switch are configured to be controlled to conduct by the control unit when the control unit receives the second trigger instruction.

The digital-to-analog conversion unit is connected to the third voltage detection unit, the fourth voltage detection unit and the control unit, and used for obtaining the detection results of the third voltage detection unit and the fourth voltage detection unit respectively and used for outputting a corresponding second conversion value. The control unit is configured to output the insulation resistance value of the joint under test according to the second conversion value when receiving the second trigger instruction.

Preferably, in the joint resistance measurement device of the present invention, further comprising a discharge unit connected to the third connection end. The discharge unit is used for discharging the insulating layer of the joint under test when the constant voltage source is in the off state.

Preferably, in the joint resistance measurement device of the present invention, further comprising an executionunit. The execution unit is used for controlling the uniform shaking of the joint. The control unit is used for obtaining the maximum value and the minimum value of the continuous resistance value during the shaking process of the joint under test, and obtaining the difference obtained by subtracting the minimum value from the maximum value as the shaking resistance value of the joint.

Preferably, in the joint resistance measurement device of the present invention, the control unit is also used for obtaining the average value of the continuous resistance value within a preset time period as the average resistance value of the joint under test.

Preferably, in the joint resistance measurement device of the present invention, further comprising a resistance calibration unit. The first end of the resistance calibration unit is connected to the constant current source, the second end of the resistance calibration unit is connected to the second voltage detection unit, the third end of the resistance calibration unit is connected to the first voltage detection unit, and the fourth end of the resistance calibration unit is connected to the control unit. The conduction or shutdown of the resistance calibration unit is controlled by the control unit.

Preferably, in the joint resistance measurement device of the present invention, further comprising a zero calibration unit. The first end of the zero calibration unit is connected to the first voltage detection unit, the second end of the zero calibration unit is connected to the second voltage detection unit, and the third end of the zero calibration unit is connected to the control unit. The conduction or shutdown of the zero calibration unit is controlled by the control unit.

Preferably, in the joint resistance measurement device of the present invention, the constant current source comprises a power supply unit, a first operational amplifier, a first capacitor, a first bidirectional diode, a first resistor, a second resistor, a first relay switch, a first diode and a first MOS transistor.

The first pin of the first operational amplifier is connected to the input end of the first relay switch. The second pin of the first operational amplifier is grounded. The third pin of the first operational amplifier is connected to the first end of the first resistor. The second end of the first resistor is used for inputting a reference voltage. The fourth pin of the first operational amplifier is connected to the third end of the first bidirectional diode. The first end of the first bidirectional diode is used for inputting a first voltage, and the second end of the first bidirectional diode is used for inputting a second voltage. The fifth pin of the first operational amplifier is connected to the power supply unit.

The output end of the first relay switch is connected to the anode of the first diode. The cathode of the first diode is connected to the drain of the first MOS transistor. The source of the first MOS transistor is connected to the first end of the second resistor. The second end of the second resistor is connected to the first changeover switch. The control end of the first relay switch is connected to the control unit, and the first relay switch is configured to be controlled to conduct by the control unit when the control unit receives the first trigger instruction.

Preferably, in the joint resistance measurement device of the present invention, the first voltage detection unit comprises a second relay switch and a third resistor. The input end of the second relay switch is connected to the first changeover switch, the output of the second relay switch is connected to the first end of the third resistor, the second end of the third resistor is connected to the digital-to-analog conversion unit, and the control end of the second relay switch is connected to the control unit. Moreover, the second relay switch is configured to be controlled to conduct by the control unit when the control unit receives the first trigger instruction. And/or

The second voltage detection unit includes a fourth resistor and a fifth resistor. The first end of the fourth resistor is connected to the second changeover switch. The second end of the fourth resistor is connected to the digital-to-analog conversion unit. The first end of the fifth resistor is connected to the second changeover switch, and the second end of the fifth resistor is grounded.

Preferably, in the joint resistance measurement device of the present invention, the first voltage division unit comprises a sixth resistor, a seventh resistor and a second diode. The first end of the sixth resistor is connected to the third changeover switch. The second end of the sixth resistor is connected to the first end of the seventh resistor and the third voltage detection unit. The second end of the seventh resistor is connected to the anode of the second diode, and the cathode of the second diode is grounded.

The second voltage division unit comprises an eighth resistor and a ninth resistor. The first end of the eighth resistor is connected to the fourth changeover switch. The second end of the eighth resistor is connected to the first end of the ninth resistor and the fourth voltage detection unit. The second end of the ninth resistor is connected to the anode of the second diode.

Preferably, in the joint resistance measurement device of the present invention, the third voltage detection unit comprises a second operational amplifier, a third relay switch, a tenth resistor and an eleventh resistor. The third pin of the second operational amplifier is connected to the second end of the seventh resistor. The fourth pin of the second operational amplifier is connected to the first pin of the second operational amplifier and the first end of the tenth resistor. The second end of the tenth resistor is connected to the input end of the third relay switch. The output end of the third relay switch is connected to the first end of the eleventh resistor, and the second end of the eleventh resistor is connected to the digital-to-analog conversion unit. The control end of the third relay switch is connected to the control unit, and the third relay switch is configured to be controlled to conduct by the control unit when the control unit receives the second trigger instruction.

The fourth voltage detection unit comprises a third operational amplifier, a fourth relay switch and a twelfth resistor. The third pin of the third operational amplifier is connected to the second end of the ninth resistor. The fourth pin of the third operational amplifier is connected to the first pin of the third operational amplifier and the first end of the twelfth resistor. The second end of the twelfth resistor is connected to the input end of the fourth relay switch. The output end of the fourth relay switch is connected to the first end of the eleventh resistor. The control end of the fourth relay switch is connected to the control unit, and the fourth relay switch is configured to be controlled to conduct by the control unit when the control unit receives the second trigger instruction

### BENEFICIAL EFFECTS OF THE INVENTION

Implementing a joint resistance measurement device of the present invention has following beneficial effects: through a simple circuit design, one-click trigger testing of joint resistance is achieved, which can effectively improve the efficiency of joint testing and reduce the cost of labor input.

### BRIEF DESCRIPTION OF THE ACCOMPANYING DRAWINGS

The present invention will be further described below in combination with the accompanying drawings and embodiments. In the accompanying drawings:
FIG. 1 is a structural schematic diagram of an embodiment of a joint resistance measurement device of the present invention;
FIG. 2 is a structural schematic diagram of another embodiment of a joint resistance measurement device of the present invention;
FIG. 3 is a partial circuit schematic diagram of an embodiment of a joint resistance measurement device of the present invention;
FIG. 4 is a partial circuit schematic diagram of another embodiment of a joint resistance measurement device of the present invention.

### DETAILED DESCRIPTION OF THE INVENTION

In order to have a clearer understanding of the technical features, purposes and effects of the present invention, the specific embodiments of the present invention will now be described in detail with reference to the accompanying drawings.

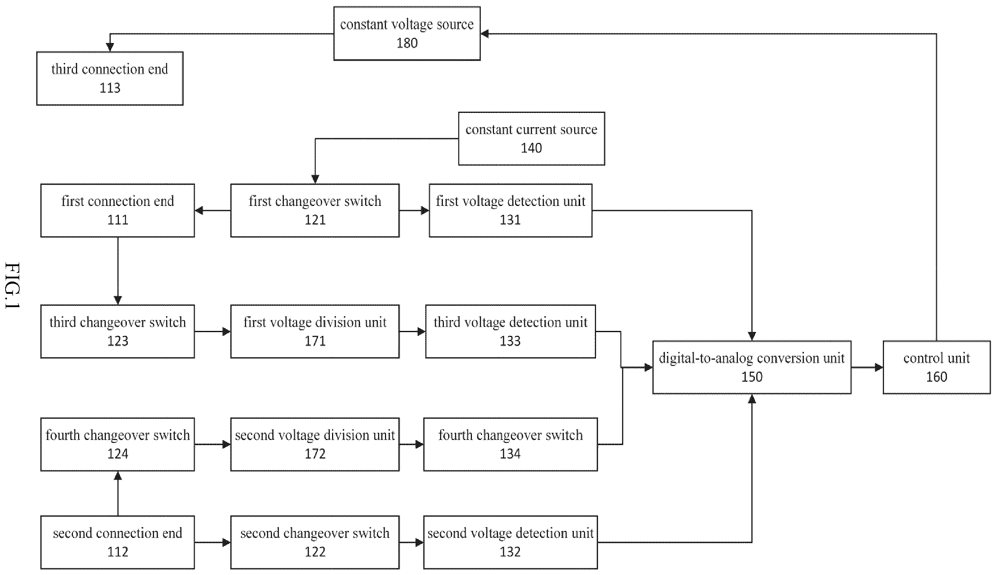

As shown in FIG. 1, in the first embodiment of a joint resistance measurement device of the present invention, it comprising: a control unit 160, a constant current source 140, a first connection end 111, a second connection end 112, a first changeover switch 121, a second changeover switch 122, a first voltage detection unit 131, a second voltage detection unit 132, a digital-to-analog conversion unit 150. The first connection end 111 and the second connection end 112 are used to correspondingly connect the inner core and the outer core of the joint under test. The first changeover switch 121 is respectively connected to the control unit 160, the first connection end 111, the constant current source 140 and the first voltage detection unit 131. The second changeover switch 122 is respectively connected to the control unit 160, the second connection end 112 and the second voltage detection unit 132. The constant current source 140 is connected to the control unit 160 and is used for generating a stable current when the control unit 160 receives a first trigger instruction. The first changeover switch 121 and the second changeover switch 122 are configured to be controlled to conduct by the control unit 160 when the control unit 160 receives the first trigger instruction. The digital-to-analog conversion unit 150 is connected to the first voltage detection unit 131, the second voltage detection unit 132 and the control unit 160, and is used for obtaining the detection results of the first voltage detection unit 131 and the second voltage detection unit 132 and outputting a corresponding first conversion value. The control unit 160 is configured to output the continuous resistance value of the joint according to the first conversion value when receiving the first trigger instruction.

Specifically, the first connection end 111 and the second connection end 112 are respectively used to connect the inner core and the outer core of the joint under test. When measuring the continuous resistance of the joint under test, the control unit 160 triggers the constant current source 140 to output a stable current according to the first trigger instruction. Meanwhile, it controls the first changeover switch 121 to conduct and the second changeover switch 122 to conduct. When the first changeover switch 121 is conducting, the stable current output by the constant current source 140 generates a voltage at the first connection end 111, and this voltage is obtained through the first voltage detection unit 131. The constant current output by the constant current source 140 passes through the inner core and the outer core of the joint (at this time, it is equivalent to being connected by a resistor with a certain resistance value between the inner core and the outer core), and then is connected to the second voltage detection unit 132 through the conducting second changeover switch 122. The output voltage of the second changeover switch 122 is obtained through the second voltage detection unit 132. At this time, it can be understood that the voltages on the inner core and the outer core of the joint are obtained respectively. By obtaining the voltage difference between the two voltages and according to the constant current provided by the constant current source 140, the continuous resistance value of the joint can be obtained. Wherein, the voltage values obtained by the first voltage detection unit 131 and the second voltage detection unit 132 are all subjected to digital-to-analog conversion by the digital-to-analog conversion unit 150, and the control unit obtains the corresponding continuous resistance value based on the digital-to-analog conversion value. The first trigger instruction can be understood as an instruction that triggers the control unit 160 to measure the continuous resistance value. That is to say, through this process, the measurement result of the continuous resistance of the joint can be one-click achieved.

Optionally, in an embodiment of a joint resistance measurement device of the present invention, further comprises: a constant voltage source 180, a third connection end 113, a first voltage division unit 171, a second voltage division unit 172, a third changeover switch 123, a fourth changeover switch 124, a third voltage detection unit 133 and a fourth voltage detection unit 134. The third connection end 113 is used to connect the insulating layer of the joint under test. The constant voltage source 180 is connected to the second connection end 112 and the control unit 160, and is used for outputting a stable voltage when the control unit 160 receives a second trigger instruction. The third changeover switch 123 is respectively connected to the control unit 160, the first connection end 111 and the first voltage division unit 171. The fourth changeover switch 124 is respectively connected to the control unit 160, the second connection end 112 and the second voltage division unit 172. The third voltage detection unit 133 is connected to the first voltage division unit 171, and the fourth voltage detection unit 134 is connected to the second voltage division unit 172. Moreover, the third changeover switch 123 and the fourth changeover switch 124 are configured to be controlled to conduct by the control unit 160 when the control unit 160 receives the second trigger instruction. The digital-to-analog conversion unit 150 is connected to the third voltage detection unit 133, the fourth voltage detection unit 134 and the control unit 160, and is used for obtaining the detection results of the third voltage detection unit 133 and the fourth voltage detection unit 134 respectively and outputting a corresponding second conversion value. The control unit 160 is configured to output the insulation resistance value of the joint according to the second conversion value when receiving the second trigger instruction.

The third connection end 113 is used to connect the insulating layer of the joint under test. When measuring the insulation resistance of the j oint, the control unit 160 triggers the constant voltage source 180 to generate a stable voltage according to the second trigger instruction, and simultaneously controls the third changeover switch 123 and the fourth changeover switch 124 to conduct respectively. Take an example where the first connection end 111 is connected to the inner core of the joint and the second connection end 112 is connected to the inner core of the joint under test. The stable voltage generated by the constant voltage source 180 forms a leakage current between the third connection end 113 and the first connection end 111. Due to the effect of this leakage current, a corresponding output voltage is formed at the output end of the first voltage division unit 171, and the output voltage is obtained by the third voltage detection unit 133, and the detected value of the output voltage is converted by the digital-to-analog conversion unit 150 to obtain a conversion value. The control unit 160 obtains the detected value of the leakage current based on the conversion value, and the insulation resistance between the insulating layer and the inner core of the joint can be obtained based on the detected value and the stable voltage output by the constant voltage source 180. The stable voltage generated by the constant voltage source 180 forms a leakage current between the third connection end 113 and the second connection end 112. Due to the effect of this leakage current, a corresponding output voltage is formed at the output end of the second voltage division unit 172. This output voltage is obtained by the fourth voltage detection unit 134, and the detected value of the output voltage is converted by the digital-to-analog conversion unit 150 to obtain a conversion value. The control unit 160 obtains the detected value of the leakage current based on the conversion value, and the insulation resistance between the insulating layer and the outer core of the joint can be obtained based on this detected value and the stable voltage output by the constant voltage source 180. Finally, the insulation resistance test value of the joint is obtained. The second trigger instruction can be understood as an instruction that triggers the control unit 160 to measure the insulation resistance value. That is to say, through this process, the measurement result of the insulation resistance of the joint can be one-click achieved.

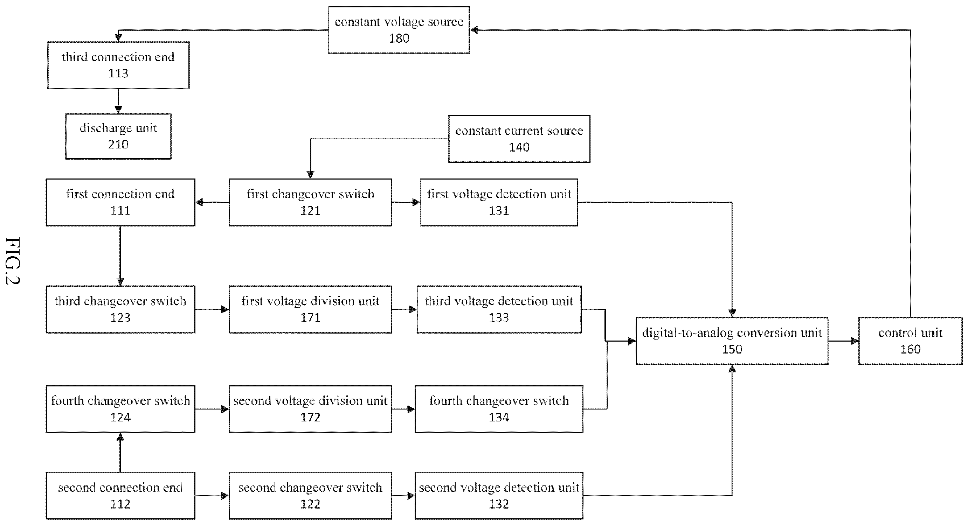

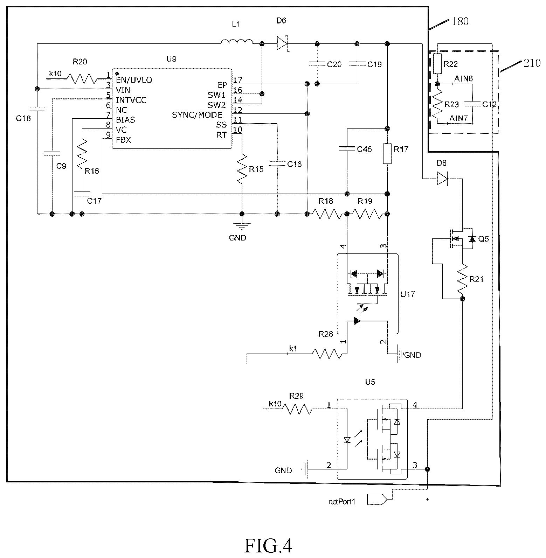

Optionally, as shown in FIG. 2, in the joint resistance measurement device of the present invention, further comprising a discharge unit 210 connected to the third connection end 113. The discharge unit 210 is used for discharging the insulating layer of the joint under test when the constant voltage source 180 is in an off state. Specifically, when the insulation resistance test of the joint is completed, due to the effect of the supply voltage of the constant current source 140, a large number of charges are left on the insulating layer of the joint. Because of the insulating effect of the insulating layer, these charges cannot be released externally. In order to prevent these charges from damaging the internal circuits of the measurement device, a discharge unit is set at the third connection end 113, and this discharge unit discharges the insulating layer of the joint when the constant voltage source 180 is in an off state. In one embodiment, as shown in FIG. 4, the discharge unit 210 includes a resistor R22, a resistor R23 and a capacitor C12.

Optionally, in the joint resistance measurement device of the present invention, further comprising an execution unit. The execution unit is used for controlling the uniform shaking of the joint under test. The control unit 160 is used for obtaining the maximum and minimum values of the continuous resistance value during the shaking process of the joint, and obtaining the difference obtained by subtracting the minimum value from the maximum value as the shaking resistance value of the j oint. Specifically, the uniform shaking of the joint can be controlled by a mechanical or electrical execution unit. During the shaking process of the joint, the maximum and minimum values of the measured continuous resistance are obtained, and the difference between the maximum and minimum values is taken as the shaking resistance value of the joint. It can be understood that the magnitude of the shaking resistance value may be related to the measurement duration of the continuous resistance value. The duration of the execution unit can be set to obtain the shaking resistance value corresponding to the time.

Optionally, the control unit 160 is also used for obtaining the average value of the continuous resistance values within a preset time period as the average resistance value of the joint under test. Specifically, for the continuous resistance value of the joint, since the continuous resistance value may change, in practical applications, it is more preferable to obtain the average value of the joint as the calculation parameter for its use. The measurement of the average resistance value can be obtained based on the average value of the continuous resistance values of the joint within a certain period of time. Through reasonable presetting of the time period, the obtained average resistance value can more truly reflect the state of the joint.

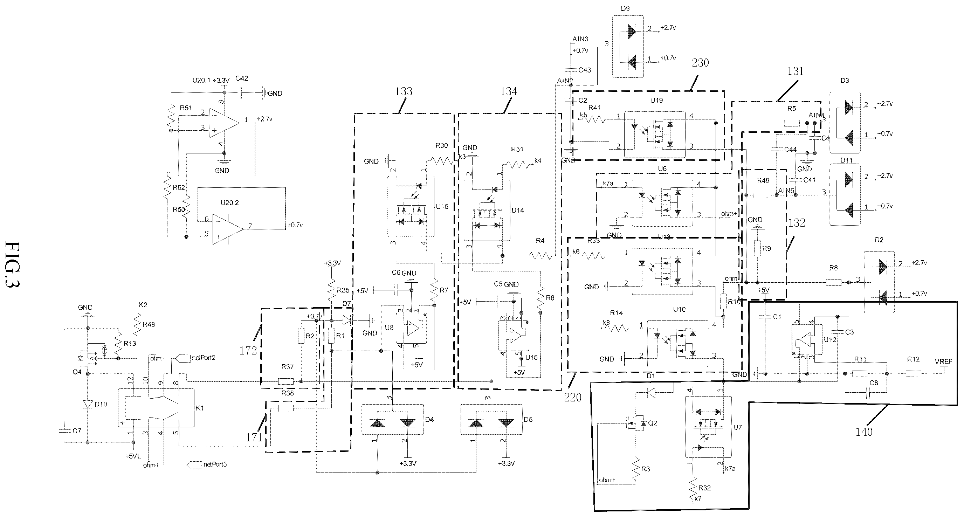

As shown in FIG. 3, the constant current source 140 comprises a power supply unit, a first operational amplifier U12, a first capacitor C3, a first bidirectional diode D2, a first resistor R12, a second resistor R3, a first relay switch U7, a first diode D1 and a first MOS transistor Q2. The first pin of the first operational amplifier U12 is connected to the input end of the first relay switch. The second pin of the first operational amplifier U12 is grounded. The third pin of the first operational amplifier U12 is connected to the first end of the first resistor. The second end of the first resistor is used to input a reference voltage. The fourth pin of the first operational amplifier U12 is connected to the third end of the first bidirectional diode D2. The first end of the first bidirectional diode D2 is used for inputting a first voltage, and the second end of the first bidirectional diode D2 is used for inputting a second voltage. The fifth pin of the first operational amplifier U12 is connected to the power supply unit. The output end of the first relay switch U7 is connected to the anode of the first diode D1. The cathode of the first diode D1 is connected to the drain of the first MOS transistor Q2. The source of the first MOS transistor Q2 is connected to the first end of the second resistor R3. The second end of the second resistor R3 is connected to the first changeover switch 121. The control end of the first relay switch U7 is connected to the control unit 160, and the first relay switch U7 is configured to be controlled to conduct by the control unit 160 when the control unit 160 receives a first trigger instruction. Specifically, in the circuit of the constant current source 140, a constant current is generated by the first operational amplifier U12. In one embodiment, the constant current is 1 mA. The constant current passes through the first relay switch and is input to the first changeover switch 121 through the first diode D1 and the first MOS transistor Q2. When the first changeover switch 121 is conducting, it directly acts on the outer core or the inner core of the joint under test. Wherein the role of the first bidirectional diode D2 is to limit the voltage of pin 4 of the first operational amplifier U12, prevent a voltage higher than the power supply voltage from being introduced during resistance measurement and damage the first operational amplifier U12. By setting the first voltage to 0.7 V and the second voltage to 2.7 V, the voltage of pin 4 of the first operational amplifier U12 can be limited between 0 V and 3.4 V. Wherein, whether the constant current source 140 participates in the measurement process can be controlled by controlling the conduction or shutdown of the first relay switch through the control unit 160.

Optionally, the first voltage detection unit 131 comprises a second relay switch U6 and a third resistor R5. The input end of the second relay switch U6 is connected to the first changeover switch 121. The output of the second relay switch U6 is connected to the first end of the third resistor R5. The second end of the third resistor R5 is connected to the digital-to-analog conversion unit 150. The control end of the second relay switch U6 is connected to the control unit 160, and the second relay switch U6 is configured to be controlled to conduct by the control unit 160 when the control unit 160 receives the first trigger instruction. Specifically, in the first voltage detection unit 131, the detection voltage is obtained by voltage division through the third resistor R5. This voltage detection unit can participate in the circuit operation according to the control instruction of the control unit 160. In one embodiment, a bidirectional diode D3 is simultaneously connected to the second end of the third resistor R5, and voltage limiting protection is carried out through the bidirectional diode to prevent the output voltage at the second end of the third resistor R5 from being too high and damaging the digital-to-analog conversion unit 150.

Optionally, the second voltage detection unit 132 comprises a fourth resistor R49 and a fifth resistor R9. The first end of the fourth resistor R49 is connected to the second changeover switch 122. The second end of the fourth resistor R49 is connected to the digital-to-analog conversion unit 150. The first end of the fifth resistor R9 is connected to the second changeover switch 122, and the second end of the fifth resistor R9 is grounded. Specifically, a voltage division can be obtained by connecting the fifth resistor R9 in series with the j oint under test, and the voltage detection result of the voltage division can be obtained through the fourth resistor R49.

Optionally, in the joint resistance measurement device of the present invention, further comprising a resistance calibration unit 220. The first end of the resistance calibration unit 220 is connected to the constant current source 140, the second end of the resistance calibration unit 220 is connected to the second voltage detection unit 132, the third end of the resistance calibration unit 220 is connected to the first voltage detection unit 131, and the fourth end of the resistance calibration unit 220 is connected to the control unit 160. The conduction or shutdown of the resistance calibration unit is controlled by the control unit 160.Specifically, the control unit 160 can be used for controlling the resistance calibration unit 220 to conduct, and the measurement results can be calibrated by the resistance calibration unit 220. In one embodiment, as shown in FIG. 3, the resistance calibration unit 220 includes a relay switch U13, a relay switch U10 and a standard resistor R10. When calibrating the test resistance value, the control unit 160 controls the relay switch U10 and the relay switch U13 to conduct, so that the voltages obtained by the first voltage detection unit 131 and the second voltage detection unit 132 are the voltages across the standard resistor R10. The calibration value is obtained according to the comparison result between the measured value and the actual value of the standard resistor R10, and the measurement results of the joint under test are calibrated by this calibration value. Meanwhile, when the relay switch U13 is conducting, the first voltage detection unit 131 can obtain the maximum value of the corresponding measurement voltage, that is, the full-scale test value.

Optionally, in the joint resistance measurement device of the present invention, further comprising a zero calibration unit 230. The first end of the zero calibration unit 230 is connected to the first voltage detection unit 131, the second end of the zero calibration unit 230 is connected to the second voltage detection unit 132, and the third end of the zero calibration unit 230 is connected to the control unit 160. The control unit 160 controls the zero calibration unit 230 conduction or shutdown. Specifically, the zero calibration of the voltage difference between the first voltage detection unit 131 and the second voltage detection unit 132 is achieved by the zero calibration unit 230. The control unit 160 can be used for control the zero calibration unit to conduct. And then, the first voltage detection unit 131 and the second voltage detection unit 132 are directly connected. The resistance value obtained according to the first voltage detection unit 131 and the second voltage detection unit 132 should be zero. The difference from the theoretical value is obtained according to the actual measurement result, and the difference is calibrated so that the measured value is zero. Finally, the zero calibration result is obtained.

Optionally, the first voltage division unit 171 includes a sixth resistor R38, a seventh resistor R1 and a second diode D7. The first end of the sixth resistor is connected to the third changeover switch 123, the second end of the sixth resistor is connected to the first end of the seventh resistor and the third voltage detection unit 133, the second end of the seventh resistor is connected to the anode of the second diode D7, and the cathode of the second diode D7 is grounded. Specifically, through the combined action of the sixth resistor R38, the seventh resistor R1 and the second diode D7, a divided voltage is formed at the second end of the sixth resistor R38. The third voltage detection unit 133 is used to detect the divided voltage and finally obtain the corresponding converted value. Simple understanding, it obtains the measured value of the leakage current by measuring the voltage.

Optionally, the second voltage division unit 172 includes an eighth resistor R37 and a ninth resistor R2. The first end of the eighth resistor R37 is connected to the fourth changeover switch 124, the second end of the eighth resistor R37 is connected to the first end of the ninth resistor R2 and the fourth voltage detection unit 134, and the second end of the ninth resistor R2 is connected to the anode of the second diode D7. Specifically, through the combined action of the eighth resistor R37, the ninth resistor R2 and the second diode D7, a divided voltage is formed at the second end of the eighth resistor R37. The fourth voltage detection unit 134 is used to detect the divided voltage and finally obtain the corresponding converted value. Simple understanding, it obtains the measured value of the leakage current by measuring the voltage.

Optionally, the third voltage detection unit 133 includes a second operational amplifier U8, a third relay switch U15, a tenth resistor R7 and an eleventh resistor R4. The third pin of the second operational amplifier U8 is connected to the second end of the seventh resistor. The fourth pin of the second operational amplifier U8 is connected to the first pin of the second operational amplifier U8 and the first end of the tenth resistor R7. The second end of the tenth resistor R7 is connected to the input end of the third relay switch U15. The output end of the third relay switch U15 is connected to the first end of the eleventh resistor R4, and the second end of the eleventh resistor R4 is connected to the digital-to-analog conversion unit 150. The control end of the third relay switch U15 is connected to the control unit 160, and the third relay switch U15 is configured to be controlled to conduct by the control unit 160 when the control unit 160 receives the second trigger instruction. Specifically, the corresponding voltage value generated based on the detected leakage current is obtained through the second operational amplifier U8. The third relay switch U15 is controlled to conduct by the control unit 160, and the corresponding detection value is obtained and converted in the digital-to-analog conversion unit 150. Wherein, a bidirectional diode D4 is set at the first pin of the second operational amplifier U8, and this bidirectional diode D4 is used to limit the input voltage of the first pin of the second operational amplifier U8 so as to protect this operational amplifier.

The fourth voltage detection unit 134 includes a third operational amplifier U16, a fourth relay switch U14 and a twelfth resistor R6. The third pin of the third operational amplifier U16 is connected to the second end of the ninth resistor. The fourth pin of the third operational amplifier U16 is connected to the first pin of the third operational amplifier U16 and the first end of the twelfth resistor R6. The second end of the twelfth resistor R6 is connected to the input end of the fourth relay switch U14, and the output end of the fourth relay switch U14 is connected to the first end of the eleventh resistor R4. The control end of the fourth relay switch U14 is connected to the control unit 160, and the fourth relay switch U14 is configured to be controlled to conduct by the control unit 160 when the control unit 160 receives the second trigger instruction. Specifically, the corresponding voltage value generated based on the detected leakage current is obtained through the third operational amplifier U16. The fourth relay switch U14 is controlled to conduct by the control unit 160, and the corresponding detection value is obtained and converted in the digital-to-analog conversion unit 150. Wherein, a bidirectional diode D5 is set at the first pin of the third operational amplifier U16, and this bidirectional diode D5 is used for limiting the input voltage of the first pin of the third operational amplifier U16 so as to protect this operational amplifier.

Optionally, in the joint resistance measurement device of the present invention, a user input unit is also provided, and the user input unit can be a button or a touch screen. In this measurement device, a display unit is also provided for displaying the measurement results, where the display unit can be a touch screen. The touch screen can be used as both an input unit and an output unit at the same time.

Optionally, in the joint resistance measurement device of the present invention, the first changeover switch 121, the second changeover switch 122, the third changeover switch 123 and the fourth changeover switch 124 are integrated into the same switch chip, and the conduction or disconnection of the connection ends is achieved through different pins of this switch chip. As shown in FIG. 3, the third pin and the fourth pin of the switch chip K1 are the first changeover switch 121, the ninth pin and the tenth pin of the switch chip K1 are the second changeover switch 122, the fourth pin and the fifth pin of the switch chip K1 are the third changeover switch 123, and the eighth pin and the ninth pin of the switch chip K1 are the fourth changeover switch 124. Among them, the ninth pin and the fourth pin of the switch chip K1 are respectively used to connect the inner core and the outer core of the joint under test.

Optionally, in the joint resistance measurement device of the present invention, the constant voltage source can be composed of a power supply chip U9 and its peripheral circuits. It can select 100V or 50V constant voltage sources for constant voltage output.

It should be understood that the above embodiments only represent the preferred implementation modes of the present invention. Although the descriptions are relatively specific and detailed, they should not be construed as limitations on the patent scope of the present invention. It should be noted that, for ordinary technicians in the relevant field, on the premise of not departing from the concept of the present invention, they can freely combine the above technical features, and can also make several modifications and improvements, as long as these fall within the protection scope of the present invention. Therefore, equivalent transformations and modifications made within the scope of the claims of the present invention shall fall within the coverage scope of the claims of the present invention.

## Claims

1. A joint resistance measurement device, comprising: a control unit (160), a constant current source (140), a first connection end (111), a second connection end (112), a first changeover switch (121), a second changeover switch (122), a first voltage detection unit (131), a second voltage detection unit (132), a digital-to-analog conversion unit (150);
the first connection end (111) and the second connection end (112) are used to correspondingly connect the inner core and the outer core of the joint under test; the first changeover switch (121) is respectively connected to the control unit (160), the first connection end (111), the constant current source (140) and the first voltage detection unit (131), and the second changeover switch (122) is respectively connected to the control unit (160), the second connection end (112) and the second voltage detection unit (132).
the constant current source (140) is connected to the control unit (160) and is used for generating a stable current when the control unit (160) receives a first trigger instruction; the first changeover switch (121) and the second changeover switch (122) are configured to be controlled to conduct by the control unit (160) when the control unit (160) receives the first trigger instruction; the digital-to-analog conversion unit (150) is connected to the first voltage detection unit (131), the second voltage detection unit (132) and the control unit (160), and is used for obtaining the detection results of the first voltage detection unit (131) and the second voltage detection unit (132) and outputting a corresponding first converted value; the control unit (160) is configured to output a continuous resistance value of the joint under test according to the first converted value when receiving the first trigger instruction.

2. The joint resistance measurement device according to claim 1, wherein the joint resistance measurement device further comprising: a constant voltage source (180), a third connection end (113), a first voltage division unit (171), a second voltage division unit (172), a third changeover switch (123), a fourth changeover switch (124), a third voltage detection unit (133) and a fourth voltage detection unit (134);
the third connection end (113) is used to connect the insulating layer of the joint under test;
the constant voltage source (180) is connected to the second connection end (112) and the control unit (160), and used for outputting a stable voltage when the control unit (160) receives a second trigger instruction;
the third changeover switch (123) is respectively connected to the control unit (160), the first connection end (111) and the first voltage division unit (171); the fourth changeover switch (124) is respectively connected to the control unit (160), the second connection end (112) and the second voltage division unit (172); the third voltage detection unit (133) is connected to the first voltage division unit (171), and the fourth voltage detection unit (134) is connected to the second voltage division unit (172); moreover, the third changeover switch (123) and the fourth changeover switch (124) are configured to be controlled to conduct by the control unit (160) when the control unit (160) receives the second trigger instruction;
the digital-to-analog conversion unit (150) is connected to the third voltage detection unit (133), the fourth voltage detection unit (134) and the control unit (160), and is used for obtaining the detection results of the third voltage detection unit (133) and the fourth voltage detection unit (134) respectively and used for outputting the corresponding second converted value; the control unit (160) is configured to output the insulation resistance value of the joint under test according to the second converted value when receiving the second trigger instruction.

3. The joint resistance measurement device according to claim 2, wherein the joint resistance measurement device further comprising a discharge unit (210) connected to the third connection end (113), and the discharge unit (210) is used for discharging the insulating layer of the joint under test when the constant voltage source (180) is in an off state.

4. The joint resistance measurement device according to claim 1, wherein the joint resistance measurement device further comprising an execution unit, the execution unit is used for controlling the uniform shaking of the joint under test; the control unit (160) is used for obtaining the maximum value and the minimum value of the continuous resistance value during the shaking process of the joint under test, and obtaining the difference obtained by subtracting the minimum value from the maximum value as the shaking resistance value of the joint under test.

5. The joint resistance measurement device according to claim 4, wherein the control unit (160) is also used for obtaining the average value of the continuous resistance values within a preset time period as the average resistance value of the joint under test.

6. The joint resistance measurement device according to claim 1, wherein the joint resistance measurement device further comprising a resistance calibration unit (220); the first end of the resistance calibration unit (220) is connected to the constant current source (140), the second end of the resistance calibration unit (220) is connected to the second voltage detection unit (132), the third end of the resistance calibration unit (220) is connected to the first voltage detection unit (131), and the fourth end of the resistance calibration unit (220) is connected to the control unit (160); the conduction or shutdown of the resistance calibration unit (220) is controlled by the control unit (160); and/or
the joint resistance measurement device further comprising a zero calibration unit (230); the first end of the zero calibration unit (230) is connected to the first voltage detection unit (131), the second end of the zero calibration unit (230) is connected to the second voltage detection unit (132), and the third end of the zero calibration unit (230) is connected to the control unit (160), the conduction or shutdown of the zero calibration unit is controlled by the control unit (160).

7. The joint resistance measurement device according to claim 1, wherein the constant current source (140) comprises a power supply unit, a first operational amplifier (U12), a first capacitor (C3), a first bidirectional diode (D2), a first resistor (R12), a second resistor (R3), a first relay switch (U7), a first diode (D1) and a first MOS transistor (Q2);
the first pin of the first operational amplifier (U12) is connected to the input end of the first relay switch; the second pin of the first operational amplifier (U12) is grounded; the third pin of the first operational amplifier (U12) is connected to the first end of the first resistor (R12), and the second end of the first resistor (R12) is used for inputting a reference voltage; the fourth pin of the first operational amplifier (U12) is connected to the third end of the first bidirectional diode (D2); the first end of the first bidirectional diode (D2) is used for inputting a first voltage, and the second end of the first bidirectional diode (D2) is used for inputting a second voltage; the fifth pin of the first operational amplifier (U12) is connected to the power supply unit;
the output end of the first relay switch (U7) is connected to the anode of the first diode (D1); the cathode of the first diode (D1) is connected to the drain of the first MOS transistor (Q2); the source of the first MOS transistor (Q2) is connected to the first end of the second resistor (R3); the second end of the second resistor (R3) is connected to the first changeover switch (121); the control end of the first relay switch (U7) is connected to the control unit (160), and the first relay switch (U7) is configured to be controlled to conduct by the control unit (160) when the control unit (160) receives the first trigger instruction.

8. The joint resistance measurement device according to claim 1, wherein, the first voltage detection (131) unit comprises a second relay switch (U6) and a third resistor (R5); the input end of the second relay switch (U6) is connected to the first changeover switch (121), the output of the second relay switch (U6) is connected to the first end of the third resistor (R5), the second end of the third resistor (R5) is connected to the digital-to-analog conversion unit (150), the control end of the second relay switch (U6) is connected to the control unit (160), and the second relay switch (U6) is configured to be controlled to be conduct by the control unit (160) when the control unit (160) receives the first trigger instruction; and/or
the second voltage detection unit (132) comprises a fourth resistor (R49) and a fifth resistor (R9); the first end of the fourth resistor (R49) is connected to the second changeover switch (122), the second end of the fourth resistor (R49) is connected to the digital-to-analog conversion unit (150); the first end of the fifth resistor (R9) is connected to the second changeover switch (122), and the second end of the fifth resistor (R9) is grounded.

9. The joint resistance measurement device according to claim 2, wherein, the first voltage division (171) unit comprises a sixth resistor (R38), a seventh resistor (R1) and a second diode (D7); the first end of the sixth resistor (R38) is connected to the third changeover switch (123), the second end of the sixth resistor (R38) is connected to the first end of the seventh resistor (R1) and the third voltage detection unit (133), the second end of the seventh resistor (R1) is connected to the anode of the second diode (D7), and the cathode of the second diode (D7) is grounded;
the second voltage division unit (172) comprises an eighth resistor (R37) and a ninth resistor (R2); the first end of the eighth resistor (R37) is connected to the fourth changeover switch (124), the second end of the eighth resistor (R37) is connected to the first end of the ninth resistor (R2) and the fourth voltage detection unit (134), and the second end of the ninth resistor (R2) is connected to the anode of the second diode (D7).

10. The joint resistance measurement device according to claim 9, wherein the third voltage detection unit (133) comprises a second operational amplifier (U8), a third relay switch (U15), a tenth resistor (R7) and an eleventh resistor (R4); the third pin of the second operational amplifier (U8) is connected to the second end of the seventh resistor (R1), the fourth pin of the second operational amplifier (U8) is connected to the first pin of the second operational amplifier (U8) and the first end of the tenth resistor (R7), the second end of the tenth resistor (R7) is connected to the input end of the third relay switch (U15), the output end of the third relay switch (U15) is connected to the first end of the eleventh resistor (R4), and the second end of the eleventh resistor (R4) is connected to the digital-to-analog conversion unit (150); the control end of the third relay switch (U15) is connected to the control unit (160), and the third relay switch (U15) is configured to be controlled to conduct by the control unit (160) when the control unit (160) receives the second trigger instruction;
the fourth voltage detection unit (134) comprises a third operational amplifier (U16), a fourth relay switch (U14) and a twelfth resistor (R6); the third pin of the third operational amplifier (U16) is connected to the second end of the ninth resistor (R2); the fourth pin of the third operational amplifier (U16) is connected to the first pin of the third operational amplifier (U16) and the first end of the twelfth resistor (R6); the second end of the twelfth resistor (R6) is connected to the input end of the fourth relay switch (U14); the output end of the fourth relay switch (U14) is connected to the first end of the eleventh resistor (R4); the control end of the fourth relay switch (U14) is connected to the control unit (160), and the fourth relay switch (U14) is configured to be controlled to conduct by the control unit (160) when the control unit (160) receives the second trigger instruction.

## Patentansprüche

1. Eine Vorrichtung zur Messung des Verbindungswiderstands, umfassend: eine Steuereinheit (160), eine Konstantstromquelle (140), ein erstes Anschlussende (111), ein zweites Anschlussende (112), einen ersten Umschalter (121), einen zweiten Umschalter (122), eine erste Spannungserfassungseinheit (131), eine zweite Spannungserfassungseinheit (132) und eine Digital-Analog-Umwandlungseinheit (150);
das erste Anschlussende (111) und das zweite Anschlussende (112) dazu verwendet werden, den Innenkern bzw. den Außenkern der zu prüfenden Verbindung anzuschließen; der erste Umschalter (121) jeweils mit der Steuereinheit (160), dem ersten Anschlussende (111), der Konstantstromquelle (140) und der ersten Spannungserfassungseinheit (131) verbunden ist, und der zweite Umschalter (122) jeweils mit der Steuereinheit (160), dem zweiten Anschlussende (112) und der zweiten Spannungserfassungseinheit (132) verbunden ist;
die Konstantstromquelle (140) mit der Steuereinheit (160) verbunden ist und dazu verwendet wird, einen stabilen Strom zu erzeugen, wenn die Steuereinheit (160) eine erste Triggeranweisung empfängt; der erste Umschalter (121) und der zweite Umschalter (122) dazu eingerichtet sind, von der Steuereinheit (160) leitend angesteuert zu werden, wenn die Steuereinheit (160) die erste Triggeranweisung empfängt; die Digital-Analog-Umwandlungseinheit (150) mit der ersten Spannungserfassungseinheit (131), der zweiten Spannungserfassungseinheit (132) und der Steuereinheit (160) verbunden ist und dazu verwendet wird, die Erfassungsergebnisse der ersten Spannungserfassungseinheit (131) und der zweiten Spannungserfassungseinheit (132) zu erhalten und einen entsprechenden ersten umgewandelten Wert auszugeben; und die Steuereinheit (160) dazu eingerichtet ist, bei Empfang der ersten Triggeranweisung einen kontinuierlichen Widerstandswert der zu prüfenden Verbindung gemäß dem ersten umgewandelten Wert auszugeben.

2. Vorrichtung zur Messung des Verbindungswiderstands nach Anspruch 1, wobei die Vorrichtung zur Messung des Verbindungswiderstands ferner umfasst: eine Konstantspannungsquelle (180), ein drittes Anschlussende (113), eine erste Spannungsteilereinheit (171), eine zweite Spannungsteilereinheit (172), einen dritten Umschalter (123), einen vierten Umschalter (124), eine dritte Spannungserfassungseinheit (133) und eine vierte Spannungserfassungseinheit (134);
das dritte Anschlussende (113) dazu verwendet wird, die Isolierschicht der zu prüfenden Verbindung anzuschließen;
die Konstantspannungsquelle (180) mit dem zweiten Anschlussende (112) und der Steuereinheit (160) verbunden ist und dazu verwendet wird, eine stabile Spannung auszugeben, wenn die Steuereinheit (160) eine zweite Triggeranweisung empfängt;
der dritte Umschalter (123) jeweils mit der Steuereinheit (160), dem ersten Anschlussende (111) und der ersten Spannungsteilereinheit (171) verbunden ist; der vierte Umschalter (124) jeweils mit der Steuereinheit (160), dem zweiten Anschlussende (112) und der zweiten Spannungsteilereinheit (172) verbunden ist; die dritte Spannungserfassungseinheit (133) mit der ersten Spannungsteilereinheit (171) verbunden ist und die vierte Spannungserfassungseinheit (134) mit der zweiten Spannungsteilereinheit (172) verbunden ist; und der dritte Umschalter (123) und der vierte Umschalter (124) dazu eingerichtet sind, von der Steuereinheit (160) leitend angesteuert zu werden, wenn die Steuereinheit (160) die zweite Triggeranweisung empfängt;
die Digital-Analog-Umwandlungseinheit (150) mit der dritten Spannungserfassungseinheit (133), der vierten Spannungserfassungseinheit (134) und der Steuereinheit (160) verbunden ist und dazu verwendet wird, die Erfassungsergebnisse der dritten Spannungserfassungseinheit (133) bzw. der vierten Spannungserfassungseinheit (134) zu erhalten und den entsprechenden zweiten umgewandelten Wert auszugeben; und die Steuereinheit (160) dazu eingerichtet ist, bei Empfang der zweiten Triggeranweisung den Isolationswiderstandswert der zu prüfenden Verbindung gemäß dem zweiten umgewandelten Wert auszugeben.

3. Vorrichtung zur Messung des Verbindungswiderstands nach Anspruch 2, wobei die Vorrichtung zur Messung des Verbindungswiderstands ferner eine mit dem dritten Anschlussende (113) verbundene Entladeeinheit (210) umfasst und die Entladeeinheit (210) dazu verwendet wird, die Isolierschicht der zu prüfenden Verbindung zu entladen, wenn sich die Konstantspannungsquelle (180) in einem ausgeschalteten Zustand befindet.

4. Vorrichtung zur Messung des Verbindungswiderstands nach Anspruch 1, wobei die Vorrichtung zur Messung des Verbindungswiderstands ferner eine Ausführungseinheit umfasst, wobei die Ausführungseinheit dazu verwendet wird, ein gleichmäßiges Schütteln der zu prüfenden Verbindung zu steuern; und die Steuereinheit (160) dazu verwendet wird, während des Schüttelvorgangs der zu prüfenden Verbindung den Maximalwert und den Minimalwert des kontinuierlichen Widerstandswerts zu erhalten und die durch Subtrahieren des Minimalwerts von dem Maximalwert erhaltene Differenz als Schüttelwiderstandswert der zu prüfenden Verbindung zu erhalten.

5. Vorrichtung zur Messung des Verbindungswiderstands nach Anspruch 4, wobei die Steuereinheit (160) ferner dazu verwendet wird, den Mittelwert der kontinuierlichen Widerstandswerte innerhalb eines voreingestellten Zeitraums als mittleren Widerstandswert der zu prüfenden Verbindung zu erhalten.

6. Vorrichtung zur Messung des Verbindungswiderstands nach Anspruch 1, wobei die Vorrichtung zur Messung des Verbindungswiderstands ferner eine Widerstandskalibriereinheit (220) umfasst; wobei ein erstes Ende der Widerstandskalibriereinheit (220) mit der Konstantstromquelle (140) verbunden ist, ein zweites Ende der Widerstandskalibriereinheit (220) mit der zweiten Spannungserfassungseinheit (132) verbunden ist, ein drittes Ende der Widerstandskalibriereinheit (220) mit der ersten Spannungserfassungseinheit (131) verbunden ist und ein viertes Ende der Widerstandskalibriereinheit (220) mit der Steuereinheit (160) verbunden ist; wobei das Leiten oder Abschalten der Widerstandskalibriereinheit (220) von der Steuereinheit (160) gesteuert wird; und/oder
die Vorrichtung zur Messung des Verbindungswiderstands ferner eine Nullkalibriereinheit (230) umfasst; wobei ein erstes Ende der Nullkalibriereinheit (230) mit der ersten Spannungserfassungseinheit (131) verbunden ist, ein zweites Ende der Nullkalibriereinheit (230) mit der zweiten Spannungserfassungseinheit (132) verbunden ist und ein drittes Ende der Nullkalibriereinheit (230) mit der Steuereinheit (160) verbunden ist, wobei das Leiten oder Abschalten der Nullkalibriereinheit von der Steuereinheit (160) gesteuert wird.

7. Vorrichtung zur Messung des Verbindungswiderstands nach Anspruch 1, wobei die Konstantstromquelle (140) eine Stromversorgungseinheit, einen ersten Operationsverstärker (U12), einen ersten Kondensator (C3), eine erste bidirektionale Diode (D2), einen ersten Widerstand (R12), einen zweiten Widerstand (R3), einen ersten Relaisschalter (U7), eine erste Diode (D1) und einen ersten MOS-Transistor (Q2) umfasst;
ein erster Pin des ersten Operationsverstärkers (U12) mit dem Eingangsende des ersten Relaisschalters verbunden ist; ein zweiter Pin des ersten Operationsverstärkers (U12) mit Masse verbunden ist; ein dritter Pin des ersten Operationsverstärkers (U12) mit einem ersten Ende des ersten Widerstands (R12) verbunden ist und ein zweites Ende des ersten Widerstands (R12) zur Eingabe einer Referenzspannung verwendet wird; ein vierter Pin des ersten Operationsverstärkers (U12) mit einem dritten Ende der ersten bidirektionalen Diode (D2) verbunden ist; ein erstes Ende der ersten bidirektionalen Diode (D2) zur Eingabe einer ersten Spannung verwendet wird und ein zweites Ende der ersten bidirektionalen Diode (D2) zur Eingabe einer zweiten Spannung verwendet wird; und ein fünfter Pin des ersten Operationsverstärkers (U12) mit der Stromversorgungseinheit verbunden ist;
das Ausgangsende des ersten Relaisschalters (U7) mit der Anode der ersten Diode (D1) verbunden ist; die Kathode der ersten Diode (D1) mit dem Drain des ersten MOS-Transistors (Q2) verbunden ist; die Source des ersten MOS-Transistors (Q2) mit einem ersten Ende des zweiten Widerstands (R3) verbunden ist; ein zweites Ende des zweiten Widerstands (R3) mit dem ersten Umschalter (121) verbunden ist; das Steuerende des ersten Relaisschalters (U7) mit der Steuereinheit (160) verbunden ist und der erste Relaisschalter (U7) dazu eingerichtet ist, von der Steuereinheit (160) leitend angesteuert zu werden, wenn die Steuereinheit (160) die erste Triggeranweisung empfängt.

8. Vorrichtung zur Messung des Verbindungswiderstands nach Anspruch 1, wobei die erste Spannungserfassungseinheit (131) einen zweiten Relaisschalter (U6) und einen dritten Widerstand (R5) umfasst; wobei das Eingangsende des zweiten Relaisschalters (U6) mit dem ersten Umschalter (121) verbunden ist, das Ausgangsende des zweiten Relaisschalters (U6) mit einem ersten Ende des dritten Widerstands (R5) verbunden ist, ein zweites Ende des dritten Widerstands (R5) mit der Digital-Analog-Umwandlungseinheit (150) verbunden ist, das Steuerende des zweiten Relaisschalters (U6) mit der Steuereinheit (160) verbunden ist und der zweite Relaisschalter (U6) dazu eingerichtet ist, von der Steuereinheit (160) leitend angesteuert zu werden, wenn die Steuereinheit (160) die erste Triggeranweisung empfängt; und/oder
die zweite Spannungserfassungseinheit (132) einen vierten Widerstand (R49) und einen fünften Widerstand (R9) umfasst; wobei ein erstes Ende des vierten Widerstands (R49) mit dem zweiten Umschalter (122) verbunden ist, ein zweites Ende des vierten Widerstands (R49) mit der Digital-Analog-Umwandlungseinheit (150) verbunden ist; ein erstes Ende des fünften Widerstands (R9) mit dem zweiten Umschalter (122) verbunden ist und ein zweites Ende des fünften Widerstands (R9) mit Masse verbunden ist.

9. Vorrichtung zur Messung des Verbindungswiderstands nach Anspruch 2, wobei die erste Spannungsteilereinheit (171) einen sechsten Widerstand (R38), einen siebten Widerstand (R1) und eine zweite Diode (D7) umfasst; wobei ein erstes Ende des sechsten Widerstands (R38) mit dem dritten Umschalter (123) verbunden ist, ein zweites Ende des sechsten Widerstands (R38) mit einem ersten Ende des siebten Widerstands (R1) und der dritten Spannungserfassungseinheit (133) verbunden ist, ein zweites Ende des siebten Widerstands (R1) mit der Anode der zweiten Diode (D7) verbunden ist und die Kathode der zweiten Diode (D7) mit Masse verbunden ist;
die zweite Spannungsteilereinheit (172) einen achten Widerstand (R37) und einen neunten Widerstand (R2) umfasst; wobei ein erstes Ende des achten Widerstands (R37) mit dem vierten Umschalter (124) verbunden ist, ein zweites Ende des achten Widerstands (R37) mit einem ersten Ende des neunten Widerstands (R2) und der vierten Spannungserfassungseinheit (134) verbunden ist und ein zweites Ende des neunten Widerstands (R2) mit der Anode der zweiten Diode (D7) verbunden ist.

10. Vorrichtung zur Messung des Verbindungswiderstands nach Anspruch 9, wobei die dritte Spannungserfassungseinheit (133) einen zweiten Operationsverstärker (U8), einen dritten Relaisschalter (U15), einen zehnten Widerstand (R7) und einen elften Widerstand (R4) umfasst; wobei ein dritter Pin des zweiten Operationsverstärkers (U8) mit einem zweiten Ende des siebten Widerstands (R1) verbunden ist, ein vierter Pin des zweiten Operationsverstärkers (U8) mit einem ersten Pin des zweiten Operationsverstärkers (U8) und einem ersten Ende des zehnten Widerstands (R7) verbunden ist, ein zweites Ende des zehnten Widerstands (R7) mit dem Eingangsende des dritten Relaisschalters (U15) verbunden ist, das Ausgangsende des dritten Relaisschalters (U15) mit einem ersten Ende des elften Widerstands (R4) verbunden ist und ein zweites Ende des elften Widerstands (R4) mit der Digital-Analog-Umwandlungseinheit (150) verbunden ist; wobei das Steuerende des dritten Relaisschalters (U15) mit der Steuereinheit (160) verbunden ist und der dritte Relaisschalter (U15) dazu eingerichtet ist, von der Steuereinheit (160) leitend angesteuert zu werden, wenn die Steuereinheit (160) die zweite Triggeranweisung empfängt;
die vierte Spannungserfassungseinheit (134) einen dritten Operationsverstärker (U16), einen vierten Relaisschalter (U14) und einen zwölften Widerstand (R6) umfasst; wobei ein dritter Pin des dritten Operationsverstärkers (U16) mit einem zweiten Ende des neunten Widerstands (R2) verbunden ist; ein vierter Pin des dritten Operationsverstärkers (U16) mit einem ersten Pin des dritten Operationsverstärkers (U16) und einem ersten Ende des zwölften Widerstands (R6) verbunden ist; ein zweites Ende des zwölften Widerstands (R6) mit dem Eingangsende des vierten Relaisschalters (U14) verbunden ist; das Ausgangsende des vierten Relaisschalters (U14) mit einem ersten Ende des elften Widerstands (R4) verbunden ist; das Steuerende des vierten Relaisschalters (U14) mit der Steuereinheit (160) verbunden ist und der vierte Relaisschalter (U14) dazu eingerichtet ist, von der Steuereinheit (160) leitend angesteuert zu werden, wenn die Steuereinheit (160) die zweite Triggeranweisung empfängt.

## Revendications

1. Dispositif de mesure de résistance de jonction, comprenant : une unité de commande (160), une source de courant constant (140), une première extrémité de connexion (111), une deuxième extrémité de connexion (112), un premier commutateur (121), un deuxième commutateur (122), une première unité de détection de tension (131), une deuxième unité de détection de tension (132) et une unité de conversion numérique-analogique (150) ;
la première extrémité de connexion (111) et la deuxième extrémité de connexion (112) étant utilisées pour connecter respectivement le noyau interne et le noyau externe de la jonction à tester ; le premier commutateur (121) étant connecté respectivement à l'unité de commande (160), à la première extrémité de connexion (111), à la source de courant constant (140) et à la première unité de détection de tension (131), et le deuxième commutateur (122) étant connecté respectivement à l'unité de commande (160), à la deuxième extrémité de connexion (112) et à la deuxième unité de détection de tension (132) ;
la source de courant constant (140) étant connectée à l'unité de commande (160) et étant utilisée pour générer un courant stable lorsque l'unité de commande (160) reçoit une première instruction de déclenchement ; le premier commutateur (121) et le deuxième commutateur (122) étant configurés pour être commandés par l'unité de commande (160) de manière à devenir conducteurs lorsque l'unité de commande (160) reçoit la première instruction de déclenchement ; l'unité de conversion numérique-analogique (150) étant connectée à la première unité de détection de tension (131), à la deuxième unité de détection de tension (132) et à l'unité de commande (160), et étant utilisée pour obtenir les résultats de détection de la première unité de détection de tension (131) et de la deuxième unité de détection de tension (132) et délivrer une première valeur convertie correspondante ; et l'unité de commande (160) étant configurée pour délivrer une valeur de résistance continue de la jonction à tester selon la première valeur convertie lors de la réception de la première instruction de déclenchement.

2. Dispositif de mesure de résistance de jonction selon la revendication 1, dans lequel le dispositif de mesure de résistance de jonction comprend en outre : une source de tension constante (180), une troisième extrémité de connexion (113), une première unité de division de tension (171), une deuxième unité de division de tension (172), un troisième commutateur (123), un quatrième commutateur (124), une troisième unité de détection de tension (133) et une quatrième unité de détection de tension (134) ;
la troisième extrémité de connexion (113) étant utilisée pour connecter la couche isolante de la jonction à tester ;
la source de tension constante (180) étant connectée à la deuxième extrémité de connexion (112) et à l'unité de commande (160), et étant utilisée pour délivrer une tension stable lorsque l'unité de commande (160) reçoit une deuxième instruction de déclenchement ;
le troisième commutateur (123) étant connecté respectivement à l'unité de commande (160), à la première extrémité de connexion (111) et à la première unité de division de tension (171) ; le quatrième commutateur (124) étant connecté respectivement à l'unité de commande (160), à la deuxième extrémité de connexion (112) et à la deuxième unité de division de tension (172) ; la troisième unité de détection de tension (133) étant connectée à la première unité de division de tension (171), et la quatrième unité de détection de tension (134) étant connectée à la deuxième unité de division de tension (172) ; et le troisième commutateur (123) et le quatrième commutateur (124) étant configurés pour être commandés par l'unité de commande (160) de manière à devenir conducteurs lorsque l'unité de commande (160) reçoit la deuxième instruction de déclenchement ;
l'unité de conversion numérique-analogique (150) étant connectée à la troisième unité de détection de tension (133), à la quatrième unité de détection de tension (134) et à l'unité de commande (160), et étant utilisée pour obtenir respectivement les résultats de détection de la troisième unité de détection de tension (133) et de la quatrième unité de détection de tension (134) et pour délivrer la deuxième valeur convertie correspondante ; et l'unité de commande (160) étant configurée pour délivrer la valeur de résistance d'isolement de la jonction à tester selon la deuxième valeur convertie lors de la réception de la deuxième instruction de déclenchement.

3. Dispositif de mesure de résistance de jonction selon la revendication 2, dans lequel le dispositif de mesure de résistance de jonction comprend en outre une unité de décharge (210) connectée à la troisième extrémité de connexion (113), et l'unité de décharge (210) est utilisée pour décharger la couche isolante de la jonction à tester lorsque la source de tension constante (180) est dans un état désactivé.

4. Dispositif de mesure de résistance de jonction selon la revendication 1, dans lequel le dispositif de mesure de résistance de jonction comprend en outre une unité d'exécution, l'unité d'exécution étant utilisée pour commander l'agitation uniforme de la jonction à tester ; l'unité de commande (160) étant utilisée pour obtenir la valeur maximale et la valeur minimale de la valeur de résistance continue pendant le processus d'agitation de la jonction à tester, et pour obtenir la différence obtenue en soustrayant la valeur minimale de la valeur maximale en tant que valeur de résistance d'agitation de la jonction à tester.

5. Dispositif de mesure de résistance de jonction selon la revendication 4, dans lequel l'unité de commande (160) est également utilisée pour obtenir la valeur moyenne des valeurs de résistance continues dans une période de temps prédéfinie en tant que valeur de résistance moyenne de la jonction à tester.

6. Dispositif de mesure de résistance de jonction selon la revendication 1, dans lequel le dispositif de mesure de résistance de jonction comprend en outre une unité d'étalonnage de résistance (220) ; une première extrémité de l'unité d'étalonnage de résistance (220) étant connectée à la source de courant constant (140), une deuxième extrémité de l'unité d'étalonnage de résistance (220) étant connectée à la deuxième unité de détection de tension (132), une troisième extrémité de l'unité d'étalonnage de résistance (220) étant connectée à la première unité de détection de tension (131), et une quatrième extrémité de l'unité d'étalonnage de résistance (220) étant connectée à l'unité de commande (160) ; l'établissement de conduction ou la coupure de l'unité d'étalonnage de résistance (220) étant commandé par l'unité de commande (160) ; et/ou
le dispositif de mesure de résistance de jonction comprend en outre une unité d'étalonnage du zéro (230) ; une première extrémité de l'unité d'étalonnage du zéro (230) étant connectée à la première unité de détection de tension (131), une deuxième extrémité de l'unité d'étalonnage du zéro (230) étant connectée à la deuxième unité de détection de tension (132), et une troisième extrémité de l'unité d'étalonnage du zéro (230) étant connectée à l'unité de commande (160), l'établissement de conduction ou la coupure de l'unité d'étalonnage du zéro étant commandé par l'unité de commande (160).

7. Dispositif de mesure de résistance de jonction selon la revendication 1, dans lequel la source de courant constant (140) comprend une unité d'alimentation électrique, un premier amplificateur opérationnel (U12), un premier condensateur (C3), une première diode bidirectionnelle (D2), une première résistance (R12), une deuxième résistance (R3), un premier commutateur à relais (U7), une première diode (D1) et un premier transistor MOS (Q2) ;
une première broche du premier amplificateur opérationnel (U12) étant connectée à l'extrémité d'entrée du premier commutateur à relais ; une deuxième broche du premier amplificateur opérationnel (U12) étant reliée à la masse ; une troisième broche du premier amplificateur opérationnel (U12) étant connectée à une première extrémité de la première résistance (R12), et une deuxième extrémité de la première résistance (R12) étant utilisée pour recevoir une tension de référence ; une quatrième broche du premier amplificateur opérationnel (U12) étant connectée à une troisième extrémité de la première diode bidirectionnelle (D2) ; une première extrémité de la première diode bidirectionnelle (D2) étant utilisée pour recevoir une première tension, et une deuxième extrémité de la première diode bidirectionnelle (D2) étant utilisée pour recevoir une deuxième tension ; une cinquième broche du premier amplificateur opérationnel (U12) étant connectée à l'unité d'alimentation électrique ;
l'extrémité de sortie du premier commutateur à relais (U7) étant connectée à l'anode de la première diode (D1) ; la cathode de la première diode (D1) étant connectée au drain du premier transistor MOS (Q2) ; la source du premier transistor MOS (Q2) étant connectée à une première extrémité de la deuxième résistance (R3) ; une deuxième extrémité de la deuxième résistance (R3) étant connectée au premier commutateur (121) ; l'extrémité de commande du premier commutateur à relais (U7) étant connectée à l'unité de commande (160), et le premier commutateur à relais (U7) étant configuré pour être commandé par l'unité de commande (160) de manière à devenir conducteur lorsque l'unité de commande (160) reçoit la première instruction de déclenchement.

8. Dispositif de mesure de résistance de jonction selon la revendication 1, dans lequel la première unité de détection de tension (131) comprend un deuxième commutateur à relais (U6) et une troisième résistance (R5) ; l'extrémité d'entrée du deuxième commutateur à relais (U6) étant connectée au premier commutateur (121), l'extrémité de sortie du deuxième commutateur à relais (U6) étant connectée à une première extrémité de la troisième résistance (R5), une deuxième extrémité de la troisième résistance (R5) étant connectée à l'unité de conversion numérique-analogique (150), l'extrémité de commande du deuxième commutateur à relais (U6) étant connectée à l'unité de commande (160), et le deuxième commutateur à relais (U6) étant configuré pour être commandé par l'unité de commande (160) de manière à devenir conducteur lorsque l'unité de commande (160) reçoit la première instruction de déclenchement ; et/ou
la deuxième unité de détection de tension (132) comprend une quatrième résistance (R49) et une cinquième résistance (R9) ; une première extrémité de la quatrième résistance (R49) étant connectée au deuxième commutateur (122), une deuxième extrémité de la quatrième résistance (R49) étant connectée à l'unité de conversion numérique-analogique (150) ; une première extrémité de la cinquième résistance (R9) étant connectée au deuxième commutateur (122), et une deuxième extrémité de la cinquième résistance (R9) étant reliée à la masse.

9. Dispositif de mesure de résistance de jonction selon la revendication 2, dans lequel la première unité de division de tension (171) comprend une sixième résistance (R38), une septième résistance (R1) et une deuxième diode (D7) ; une première extrémité de la sixième résistance (R38) étant connectée au troisième commutateur (123), une deuxième extrémité de la sixième résistance (R38) étant connectée à une première extrémité de la septième résistance (R1) et à la troisième unité de détection de tension (133), une deuxième extrémité de la septième résistance (R1) étant connectée à l'anode de la deuxième diode (D7), et la cathode de la deuxième diode (D7) étant reliée à la masse ;
la deuxième unité de division de tension (172) comprend une huitième résistance (R37) et une neuvième résistance (R2) ; une première extrémité de la huitième résistance (R37) étant connectée au quatrième commutateur (124), une deuxième extrémité de la huitième résistance (R37) étant connectée à une première extrémité de la neuvième résistance (R2) et à la quatrième unité de détection de tension (134), et une deuxième extrémité de la neuvième résistance (R2) étant connectée à l'anode de la deuxième diode (D7).

10. Dispositif de mesure de résistance de jonction selon la revendication 9, dans lequel la troisième unité de détection de tension (133) comprend un deuxième amplificateur opérationnel (U8), un troisième commutateur à relais (U15), une dixième résistance (R7) et une onzième résistance (R4) ; une troisième broche du deuxième amplificateur opérationnel (U8) étant connectée à une deuxième extrémité de la septième résistance (R1), une quatrième broche du deuxième amplificateur opérationnel (U8) étant connectée à une première broche du deuxième amplificateur opérationnel (U8) et à une première extrémité de la dixième résistance (R7), une deuxième extrémité de la dixième résistance (R7) étant connectée à l'extrémité d'entrée du troisième commutateur à relais (U15), l'extrémité de sortie du troisième commutateur à relais (U15) étant connectée à une première extrémité de la onzième résistance (R4), et une deuxième extrémité de la onzième résistance (R4) étant connectée à l'unité de conversion numérique-analogique (150) ; l'extrémité de commande du troisième commutateur à relais (U15) étant connectée à l'unité de commande (160), et le troisième commutateur à relais (U15) étant configuré pour être commandé par l'unité de commande (160) de manière à devenir conducteur lorsque l'unité de commande (160) reçoit la deuxième instruction de déclenchement ;
la quatrième unité de détection de tension (134) comprend un troisième amplificateur opérationnel (U16), un quatrième commutateur à relais (U14) et une douzième résistance (R6) ; une troisième broche du troisième amplificateur opérationnel (U16) étant connectée à une deuxième extrémité de la neuvième résistance (R2) ; une quatrième broche du troisième amplificateur opérationnel (U16) étant connectée à une première broche du troisième amplificateur opérationnel (U16) et à une première extrémité de la douzième résistance (R6) ; une deuxième extrémité de la douzième résistance (R6) étant connectée à l'extrémité d'entrée du quatrième commutateur à relais (U14) ; l'extrémité de sortie du quatrième commutateur à relais (U14) étant connectée à une première extrémité de la onzième résistance (R4) ; l'extrémité de commande du quatrième commutateur à relais (U14) étant connectée à l'unité de commande (160), et le quatrième commutateur à relais (U14) étant configuré pour être commandé par l'unité de commande (160) de manière à devenir conducteur lorsque l'unité de commande (160) reçoit la deuxième instruction de déclenchement.
